# EUROPEAN PATENT SPECIFICATION

(11) **EP 0 230 728 B1**
(45) Date of publication and mention of the grant of the patent: **17.03.1993**
(21) Application number: 86309089.0
(22) Date of filing: 20.11.1986
(51) Int. Cl.: G03F 7/20, G11B 7/00

(54) **Photolithography**
Photolithographie
Photolithographie

(30) Priority: 21.11.1985 GB 8528698
(43) Date of publication of application: 05.08.1987
(73) Proprietor: PLASMON DATA SYSTEMS, INC., San Jose California 95110 (US)
(72) Inventor: Gardner, Keith, Foxton Cambridgeshire CB2 6SF (GB); Longman, Robert James, Coton Cambridge CB3 7PU (GB); Helfet, Peter Roy, London NW4 1SD (GB)
(74) Representative: Abrams, Michael John

(56) References cited:
- EP-A- 0 108 258
- DE-A- 2 727 646
- DE-A- 3 504 969
- FR-A- 2 339 883
- PHILIPS TECHNICAL REVIEW, vol. 40, no. 10, 1982, pages 287-297, Eindhoven, NL; H.C. HAVERKORN VAN RIJSEWIJK et al.: "Manufacture of laservision video discs by a photopolymerization process"

## Description

Photolithographic techniques are used in a variety of processes in order to generate an image carried by a substrate. A photoresist is frequently used as part of a photolithographic process. Typically, the photoresist is coated onto a substrate by spinning, dipping, spraying or any other suitable technique. The photoresist layer is then exposed to optical radiation and developed. Such a process is widely used in the fabrication of optical data storage media, e.g. disks. In such media, it is desirable to incorporate in the structure of the medium itself a tracking groove the purpose of which is to ensure proper alignment between the disk itself and an optical head which is to record (write) the surface of the disk where data is to be recorded. In addition, tracking grooves are necessary in low-cost drives in order to allow the optical head to position itself over a preselected track and to know its position relative to the disk coordinates.

The surface structure conventionally generated as a result of the use of a photoresist which is exposed and developed can conveniently be regarded as a primary surface structure. This primary surface structure is intended to confer upon the optical data storage medium at least some of the desired optical properties. Other surface structures, such as tracking grooves discussed above, can conveniently be regarded as secondary surface structures. For example, the primary surface structure may consist of a regular arrangement of grooves or protuberances, the spacing between individual pattern elements of such an arrangement being in the nanometer range (e.g. 50-400 nm). In contrast, the secondary surface structure may be a spiral tracking groove the pitch of which is in the micron range (e.g. 1.6-2.0 microns). Conventionally, the primary surface structure is generated in one process, and the secondary surface structure is generated in a separate (and possibly different type of) process. For example, the secondary surface structure may be generated in a substrate before it is coated with a photoresist, after which the primary surface structure is produced by conventional photolithographic techniques. Where it is important to ensure that the primary surface structure is regular throughout the optical storage medium, both as regards the depth of pattern and pitch of pattern, such conventional techniques are problematical in that additional process control steps are required during the exposure of the photoresist in order to ensure the desired regularity.

We have now developed a technique which greatly simplifies the production of a medium such as an optical data storage disk the surface of which carries primary and secondary structure. In this novel technique, both primary and secondary surface structure is generated photolithographically using just a single development step. More particularly, according to one aspect of the present invention there is provided a method of photolithography in which optical radiation is directed onto the surface of a thin layer of a photoresist coated on a substrate in order to generate, after development, an image carried by the substrate, the image consisting of two superimposed image elements at least one of which consists of regularly repeating pattern elements, characterised by the steps of:
(a) exposing the photoresist to optical radiation modulated so as to represent one of said two superimposed image elements;
(b) thereafter exposing the photoresist to optical radiation modulated so as to represent the other of said two superimposed image elements;
(c) developing the photoresist in a single development stage; and
(d) controlling said single development stage to ensure that total removal of photoresist material is prevented at any point on the substrate.

The single development stage takes place after the two exposure steps, there being no development process intermediate the two exposure steps. The order in which the exposures are carried out is not important; while it is convenient to characterise the two images as "first" and "second" respectively, this does not imply the order in which exposures are made. Control of the development stage is such that, after development, the substrate is still coated in all regions with a certain amount of photoresist; in other words, the deepest pit formed during development should be shallower than the initial step of the photoresist layer, there being no "cut-through" to the surface of the substrate. Our present experience shows that such control can best be achieved by using a linear development system, i.e. a combination of photoresist and developer in which there is a linear relationship between exposure level and the amount of photoresist removed during development, as opposed to conventional systems for microelectronics where there is a threshold exposure level above which there is an exponential relationship between exposure level and the amount of photoresist removed during development. As an example, the photoresist material may be Shipley Microposit 1350 and the developer may be Shipley Microposit 303 diluted 1:10 (parts by volume) with deionised water; development times of around 10 seconds should generally be satisfactory.

In many embodiments of the invention, the first and second image elements consist of regularly repeating pattern elements, the pitch of one pattern element being much greater than that of the other pattern element. For example, the first of said two superimposed image elements may consist of a regular arrangement of grooves or protuberances having a pitch in the range 100 to 800 nanometers, and the second of said two superimposed image elements may consist of a regular arrangement of grooves having a pitch in the range of 1.0 - 2.0 microns. The first of the two patterns or image elements may, for example, be a regular arrangement of grooves or protuberances, the spacing between individual pattern elements (i.e. the pitch of the pattern) being about 300 nanometers and the depth (peak-to-trough) of the pattern elements being in the range 50-150 nanometers. The second of said two image elements may, for example, comprise a spiral groove or a series of concentric grooves having a pitch of about 1.5 microns and having a depth of the same order as, or smaller than, its pitch. The second of said two image elements may also include pre-formatting material, e.g. co-ordinate information. Advantageously, the depth of said regular arrangement of grooves or protuberances which constitutes the first of the two superimposed image elements is in the range 50 - 150 nanometers.

According to a second aspect of the present invention, there is provided an optical data storage disk carrying a surface relief profile generated by a method of photolithography in which optical radiation is directed onto the surface of a thin layer of a photoresist coated on a substrate in order to generate, after development, an image carried by the substrate, the image consisting of two superimposed image elements at least one of which consists of regularly repeating pattern elements, by the steps of:
(a) exposing the photoresist to optical radiation modulated so as to represent the first of said two superimposed image elements;
(b) thereafter exposing the photoresist to optical radiation modulated so as to represent the second of said two superimposed image elements;
(c) developing the photoresist in a single development stage; and
(d) controlling said single development stage to ensure that total removal of photoresist material is prevented at any point on the substrate,
characterised in that one of said two waveforms is generally in the form of a sine wave having a pitch (period) in the range 100 to 800 nanometres and the second of said waveforms is generally in the form of a sine wave having a pitch (period) in the range 1.0 to 2.0 microns.

According to a third aspect of the present invention, there is provided an optical disk carrying a surface relief profile in the form of two superimposed substantially regular waveforms of different characteristics, the first of said waveforms being generally in the form of a sine wave and having a pitch (period) in the range 100 to 800 nanometres and the second of said waveforms being generally in the form of a sine wave and having a pitch (period) in the range 1.0 to 2.0 microns. Preferably, in such an optical disk the second of said waveforms has relatively broad 'pit' regions and relatively narrow 'land' regions. The 'pit' advantageously regions have a width in the range 0.9 to 1.4 microns and the 'land' regions have a width in the range 0.4 to 0.8 microns. Preferably, the ratio between the width of the 'pit' regions and that of the 'land' regions is at least 1.5:1, more preferably at least 2.0:1. The presently preferred dimensions are where the 'pit' regions have a width of about 1.1 microns and the 'land' regions have a width of about 0.6 microns.

The exposure steps in the method of this invention can conveniently involve the recording of interference fringes generated with the aid of a laser or a diffraction grating.

In general, it is not important which of the two image elements is the first to be formed as a latent image in the photoresist. Thus with pattern elements of the dimensions just mentioned, the second pattern (which in the finished product gives rise to tracking grooves possibly with pre-formatted co-ordinate information also) may be generated as a latent image in the first of the two exposure steps, and the primary surface structure (i.e. the first of the two patterns) may be formed as a latent image in the photoresist in the second of the two exposure steps. The reverse procedure (i.e. primary surface structure in the first exposure step and secondary surface structure in the second exposure step) is equally satisfactory.

The generation of a latent image corresponding to the primary surface structure is preferably carried out using a laser interferometer. When the primary surface structure is an arrangement of intersecting grooves or an arrangement of protuberances, a two-step exposure can be used to produce the latent image. The generation of a latent image corresponding to the secondary surface structure is preferably carried out in an automated servo-writer which monitors laser power at the disk and monitors recording quality; these two parameters determine the energy density during servo-writing compared to the energy density during exposure in the laser interferometer. The ratio between energy densities in the two exposure steps (i.e. that for primary structure and that for secondary structure) determines the reflectivity of the disk at which the tracking signal is optimised.

By operating in accordance with this invention, we have found that both surface structures are formed simultaneously in the photoresist after development. The two exposure steps operate additively.

The invention is illustrated in the following Examples:

### EXAMPLE 1

To produce a pregrooved optical disc as referred to above, the following steps were followed.

### 1. Resist Characterisation

When recording interference fringes in photoresist as in the case for the primary exposure, the image can be degraded by the effects of radiation which is reflected from the resist/glass interface. This results in so called "standing wave" effects which are in fact interference fringes lying in the plane of the resist. During the development step this can modify the primary image in an adverse way. By ensuring that the resist/developer combination is chosen such that the amount of photoresist removed is directly proportional to the exposure energy density this problem is alleviated.

To characterise the photoresist, test patterns are recorded on a prepared photoresist surface. This is achieved by contact copying a mask onto the photoresist using for example a laser light source. The pattern is copied repetitively at different locations on the surface of the photoresist using different energies for each copy. The whole operation is repeated on several prepared photoresist surfaces. The photoresist is then developed using a range of developer types, concentrations and times. It is then necessary to measure the amount of resist removed for each exposure. This can be performed using a Talystep for example. Graphs are then plotted to show which combination shows a linear relationship between amount of resist removed and exposure.

By the above procedure we have identified that using Shipley Microposit 1350 photoresist, preferably baked at a relatively low temperature, with Shipley Microposit 303 developer diluted 1 part to 10 deionised water, a linear system results.

### 2. Production

(i) A glass plate was coated with Shipley Microposit 1350 photoresist to a thickness of 0.5 microns, and baked at 60^{o} C for one hour.
(ii) The plate was exposed in a laser interferometer (wavelength 458nm) to an average energy donsity of 100 mJ/cm². This produces the primary exposure.
(iii) Without any intervening development, the plate was placed on a turntable and rotated beneath a laser beam (458nm) focussed to a circular spot size of approximately 0.8 microns. The speed of rotation was 375 r.p.m. with a laser power of 0.5 milliwatts. Using this combination of powers when the disk is developed the pregroove formed by the second step does not reach the level of the glass. This is extremely important since the noise on the finished disk is greatly increased if "cut through" occurs. The exposed photoresist was then developed with Shipley Microposit 303 developer diluted 1 part to 10 of deionised water for 12 seconds. Thereafter, an optical disk is generated from the developed photoresist surface by metallising the resist and following the steps detailed in European Patent Publication No. 0107379 and in U.S. Patent No. 4,616,237.

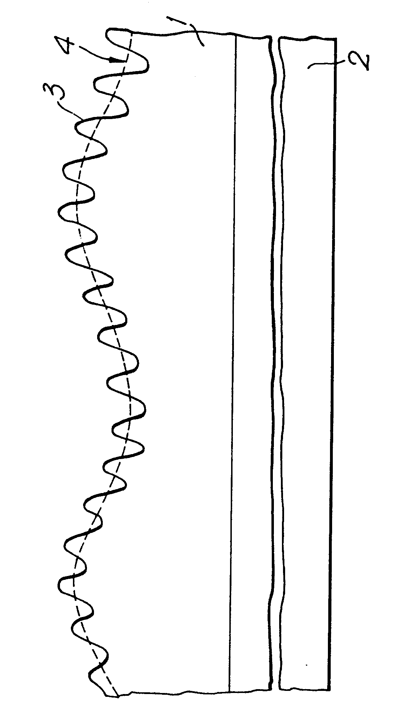

The accompanying Figure is a schematic cross-section through a photoresist 1 on a glass substrate 2 after exposure and development in accordance with this Example. The primary surface structure is apparent as the fine structure 3, while the secondary surface structure is apparent as the relatively broad grooves indicated by dashed lines 4.

### EXAMPLE 2

The procedure of Example 1 was followed except that in step (iii) an elliptical laser spot profile with dimensions 1.1 microns by 0.5 microns was used. After development of the photoresist, the broad grooves analogous to grooves 4 of the drawing were asymmetric to the extent that they comprised a relatively broad 'pit' region 1.0 microns in width and a relatively narrow 'land' region 0.6 microns in width. The depth (peak-to-trough) of the grooves was 0.1 microns. An optical disk was produced from the developed photoresist by depositing an ultra-thin film of silver over the photoresist surface, and then electrodepositing a thin nickel layer over the silver. The amount of metal deposited was sufficiently thin to avoid degrading the surface relief profile carried by the photoresist surface. Thereafter the replication steps set out in U.S. Patent 4,606,237 were followed. The resultant optical disk had a surface structure similar to that of the drawing, except that the broad grooves, which function as the tracking grooves for a laser optical head, had the degree of asymmetry described above.

### EXAMPLE 3

Optical disks produced by the methods of Example 1 and 2 were exposed, using a laser write beam directed onto the disk surface through a head using the grooves such as 4 as tracking grooves. After a standard exposure to a square wave signal of 1.5 megahertz from a laser with an output of 8 milliwatts at 800 nanometers and with the disk rotating at 1200 rpm, each disk was read using the same laser head as used to write on the disk. The output was then analysed to show the harmonic distortion present in the output. With the disk produced in accordance with Example 1, where the tracking groove was a substantially symmetrical sine wave with a pitch of 0.8 microns, the second harmonic distortion was -15dB. With the disk produced in accordance with Example 2, where the tracking grooves are not fully symmetric sine waves but have broad 'pit' regions (1.0 microns) and narrow 'land' regions (0.6 microns), the second harmonic distortion was -30dB. This demonstrates that significant improvements can be obtained in the quality of the output from an optical data storage disk if the disk has tracking grooves which are of non-symmetric form.

## Claims

1. A method of photolithography in which optical radiation is directed onto the surface of a thin layer of a photoresist coated on a substrate in order to generate, after development, an image carried by the substrate, the image consisting of two superimposed image elements at least one of which consists of regularly repeating pattern elements, characterised by the steps of:
(a) exposing the photoresist to optical radiation modulated so as to represent one of said two superimposed image elements;
(b) thereafter exposing the photoresist to optical radiation modulated so as to represent the other of said two superimposed image elements;
(c) developing the photoresist in a single development stage; and
(d) controlling said single development stage to ensure that total removal of photoresist material is prevented at any point on the substrate.

2. A method according to claim 1, wherein said first and second image elements consist of regularly repeating pattern elements, the pitch of one pattern element being much greater than that of the other pattern element.

3. A method according to claim 2, wherein one of said two superimposed image elements consists of a regular arrangement of grooves or protuberances having a pitch in the range 100 to 800 nanometers, and wherein the other of said two superimposed image elements consists of a regular arrangement of grooves having a pitch in the range 1.0 - 2.0 microns.

4. A method according to claim 3, wherein the pitch of said one of the two superimposed image elements is about 300 nanometers.

5. A method according to claim 1, 2, 3 or 4, wherein the grooves which constitute said other of the two superimposed image elements are concentric grooves.

6. A method according to claim 4 or 5, wherein the depth of said regular arrangement of grooves or protuberances which constitutes said one of the two superimposed image elements is in the range 50 - 150 nanometers.

7. An optical data storage disk carrying a surface relief profile generated by a method as claimed in any preceding claim.

8. An optical data storage disk as claimed in claim 7, wherein said disk carries a surface relief profile generally in the form of a sine wave.

9. An optical disk as claimed in claim 7, wherein said disk carries a surface relief profile in the form of two superimposed regular waveforms of different characteristics, the first of said waveforms being generally in the form of a sine wave and having a pitch (period) in the range 100 to 800 nanometres and the second of said waveforms being generally in the form of a sine wave and having a pitch (period) in the range 1.0 to 2.0 microns.

10. An optical disk as claimed in claim 9, wherein the second of said waveforms has relatively broad 'pit' regions and relatively narrow 'land' regions.

11. An optical disk as claimed in claim 10, wherein said 'pit' regions have a width in the range 0.9 to 1.4 microns and said 'land' regions have a width in the range 0.4 to 0.8 microns.

12. An optical disk as claimed in claim 11, wherein said 'pit' regions have a width of about 1.1 microns and said 'land' regions have a width of about 0.6 microns.

13. An optical disk as claimed in claim 10, wherein the ratio between the width of the 'pit' regions and that of the 'land' regions is at least 1.5:1.

14. An optical disk as claimed in claim 13, wherein said ratio is at least 2.0:1.

## Patentansprüche

1. Verfahren der Photolithographie,
bei dem optische Strahlung direkt auf die Oberfläche einer dünnen Schicht aus einem Photoresist gerichtet wird, das ein Substrat bedeckend aufgebracht ist, um nach erfolgter Entwicklung ein Bild auf dem Substrat zu erzeugen, wobei dieses Bild aus zwei überlagerten Bildelementen besteht, von denen eines derselben aus sich regulär wiederholenden Musterelementen besteht,
**gekennzeichnet** durch die Verfahrensschritte:
a) Belichten des Photoresist mit optischer Strahlung, die derart moduliert ist, daß eines dieser zwei Bildelemente vorliegt;
b) daraufhin Belichten des Photoresist mit optischer Strahlung, die derart moduliert ist, daß das andere dieser zwei überlagerten Bildelemente vorliegt;
c) Entwickeln des Photoresist in einem einzigen Vorgang; und
d) Steuern dieses einzigen Entwicklungsvorgangs derart, daß sichergestellt ist, daß vollständiges Entfernen des Photoresist an jeglichem Punkt auf dem Substrat verhindert ist.

2. Verfahren nach Anspruch 1,
bei dem diese ersten und zweiten Bildelemente aus sich regulär wiederholenden Musterelementen bestehen, wobei die Teilung des einen Musterelements viel größer ist als die des anderen Musterlements.

3. Verfahren nach Anspruch 2,
bei dem eines der zwei überlagerten Bildelemente aus einer regulären Anordnung von Gräben oder Vorsprünge mit einer Teilung im Bereich von 100 bis 800 Nanometern besteht und wobei das andere der zwei überlagerten Bildelemente aus einer regulären Anordnung von Gräben mit einer Teilung im Bereich von 1 bis 2 Mikrometer besteht.

4. Verfahren nach Anspruch 3,
bei dem die Teilung des einen der zwei überlagerten Bildelemente ungefährt 300 Nanometer beträgt.

5. Verfahren nach einem der Ansprüche 1,2,3 oder 4,
bei dem die Gräben, die das andere der zwei überlagerten Bildelemente bilden, konzentrische Gräben sind.

6. Verfahren nach Anspruch 4 oder 5,
bei dem die Tiefe dieser regulären Anordnung von Gräben oder Vorsprügnen, die das eine der zwei überlagerten Bildelemente bilden, im Bereich von 50-150 Nanometern liegt.

7. Optische Daten-Speicherplatte mit einem Oberflächen-Reliefprofil, das mit einem Verfahren nach einem der Ansprüche 1 bis 6 hergestellt ist.

8. Optische Daten-Speicherplatte nach Anspruch 7,
bei der diese Platte ein Oberflächen-Reliefprofil hat, das allgemein die Form einer Sinuswelle hat.

9. Optische Daten-Speicherplatte nach Anspruch 7,
bei der die Platte ein Oberflächen-Reliefprofil in der Form zweier überlagerter regulärer Wellenformen mit unterschiedlicher Charakteristik hat, wobei die erste dieser Wellenformen generell die Form einer Sinuswelle und eine Teilung (Periode) im Bereich von 100-800 Nanometern hat und die zweite dieser Wellenformen generell die Form einer Sinuswelle mit einer Teilung (Periode) im Bereich von 1-2 Mikrometer hat.

10. Optische Daten-Speicherplatte nach Anspruch 9,
bei der die zweite dieser Wellenformen relativ breite "Gruben"-Bereiche und relativ schmale "Land"-Bereiche hat.

11. Optische Daten-Speicherplatte nach Anspruch 10,
bei der die "Gruben"-Bereiche eine Breite im Bereich von 0,9-1,4 Mikrometer und die "Land"-Bereiche eine Breite im Bereich von 0,4-0,8 Mikrometer haben.

12. Optische Daten-Speicherplatte nach Anspruch 11,
bei der die "Gruben"-Bereiche eine Breite von etwa 1,1 Mikrometer und die "Land"-Bereiche eine Breite von etwa 0,6 Mikrometer haben.

13. Optische Daten-Speicherplatte nach Anspruch 10,
bei der das Verhältnis der Breite der "Gruben"-Bereiche und der Breite der "Land"-Bereiche wenigstens etwa 1,5 zu 1 beträgt.

14. Optische Daten-Speicherplatte nach Anspruch 13,
bei der dieses Verhältnis wenigstens 2,0 zu 1 beträgt.

## Revendications

1. Un procédé de photolithographie dans lequel un rayonnement optique est dirigé sur la surface d'une couche mince d'une photoréserve recouvrant un substrat de manière à générer, après développement, une image portée par le substrat, l'image consistant en deux éléments d'image superposés dont au moins un comprend des éléments de motifs se répétant de manière régulière, caractérisé par les opérations consistant à :
(a) exposer la photoréserve à un rayonnement optique modulé de manière à représenter un premier desdits éléments d'image superposés ;
(b) exposer ensuite la photoréserve à un rayonnement optique modulé de manière à représenter l'autre desdits deux éléments d'image superposés ;
(c) développer la photoréserve dans une étape de développement unique ; et
(d) contrôler ladite étape de développement unique pour assurer que le retrait total de la matière de photoréserve est empêché en tout point du substrat.

2. Un procédé selon la revendication 1 dans lequel lesdits premier et second éléments d'image comprennent des éléments de motif se répétant de manière régulière, le pas d'un premier élément de motif étant beaucoup plus grand que celui de l'autre élément de motif.

3. Un procédé selon la revendication 2, dans lequel un premier desdits deux éléments d'image superposés comprend un agencement régulier de rainures ou de saillies présentant un pas de l'ordre de 100 à 800 nanomètres, et dans lequel l'autre desdits éléments d'image superposés comprend un agencement régulier de rainures présentant un pas de l'ordre de 1,0 à 2,0 microns.

4. Un procédé selon la revendication 3, dans lequel le pas dudit premier des deux éléments d'image superposés est d'environ 300 nanomètres.

5. Un procédé selon les revendications 1, 2, 3 ou 4 dans lequel les rainures qui constituent ledit autre des deux éléments d'image superposés sont des rainures concentriques.

6. Un procédé selon les revendications 4 ou 5, dans lequel la profondeur dudit agencement régulier de rainures ou de saillies qui constitue ledit premier des deux éléments d'image superposés est de l'ordre de 50 à 150 nanomètres.

7. Un disque optique de stockage de données portant un profil de modelé de surface généré par un procédé comme revendiqué dans une revendication précédente quelconque.

8. Un disque optique de stockage de données comme revendiqué à la revendication 7, dans lequel ledit disque porte un profil de modulé de surface de la forme générale d'une onde sinusoïdale.

9. Un disque optique comme revendiqué à la revendication 7, dans lequel ledit disque porte un profil de modulé de surface sous la forme de deux formes d'ondes régulières superposées de caractéristiques différentes, la première desdites formes d'onde étant sous la forme générale d'une onde sinusoïdale et présentant un pas (période) de l'ordre de 100 à 800 nanomètres et la seconde desdites formes d'onde étant de manière générale de la forme d'une onde sinusoïdale et présentant un pas (période) de l'ordre de 1,0 à 2,0 microns.

10. Un disque optique comme revendiqué à la revendication 9, dans lequel la seconde desdites formes d'onde présente des régions de "creux" relativement larges et des régions de "plat" relativement étroites.

11. Un disque optique comme revendiqué à la revendication 10, dans lequel lesdites régions de "creux" présentent une largeur de l'ordre de 0,9 à 1,4 microns et lesdites régions de "plat" présentent une largeur de l'ordre de 0,4 à 0,8 micron.

12. Un disque optique comme revendiqué à la revendication 11, dans lequel lesdites régions de "creux" présentent une largeur d'environ 1,1 microns et lesdites régions de "plat" présentent une largeur d'environ 0,6 micron.

13. Un disque optique comme revendiqué à la revendication 10, dans lequel le rapport entre la largeur des régions de "creux" et celle des régions de "plat" est d'au moins 1,5:1.

14. Un disque optique comme revendiqué à la revendication 13, dans lequel ledit rapport est d'au moins 2,0:1.
